# EUROPEAN PATENT APPLICATION

(11) **EP 4 556 541 A1**
(43) Date of publication of application: **21.05.2025**
(21) Application number: 23839708.7
(22) Date of filing: 14.07.2023
(51) Int. Cl.: C09K 5/10

(54) **COOLING LIQUID FOR LIQUID IMMERSION COOLING SYSTEM**

(30) Priority: 14.07.2022 JP 2022113248
(71) Applicant: ENEOS Corporation, Chiyoda-ku Tokyo 100-8162 (JP)
(72) Inventor: TAKAHASHI Hitoshi, Tokyo 100-8162 (JP); ITO Fumitaka, Tokyo 100-8162 (JP)
(74) Representative: Gilani, Anwar
(86) International application number: PCT/JP2023/026107
(87) International publication number: WO 2024/014539

(57) **Abstract**

A cooling liquid for a liquid immersion cooling system is provided, which is contained in a liquid immersion tank of a liquid immersion cooling system as a cooling liquid, the cooling liquid containing a hydrocarbon oil in an amount of 50% by mass or more with respect to the total amount of the cooling liquid for a liquid immersion cooling system in which the cooling liquid for a liquid immersion cooling system contains no amine-based antioxidant, or in a case of further containing the antioxidant, the content thereof is less than 0.01% by mass with respect to the total amount of the cooling liquid for a liquid immersion cooling system, a 5% distillation temperature is 320°C or higher, a %C_{N} is 30.0 or less, and a kinematic viscosity at 40°C is 11.5 mm²/s or more.

## Description

### Technical Field

The present invention relates to a cooling liquid for a liquid immersion cooling system.

Priority is claimed on Japanese Patent Application No. 2022-113248, filed on July 14, 2022, the content of which is incorporated herein by reference.

### Background Art

With the rapid increase in the amount of data transmission and reception, a load on a supercomputer or a data server has increased, and an amount of heat generated by these electronic devices has also increased. In the past, an air cooling method has been mainstream as a cooling method of these electronic devices, but an air cooling type has a limit in cooling efficiency, and thus a liquid immersion type having higher cooling efficiency has been attracting attention.

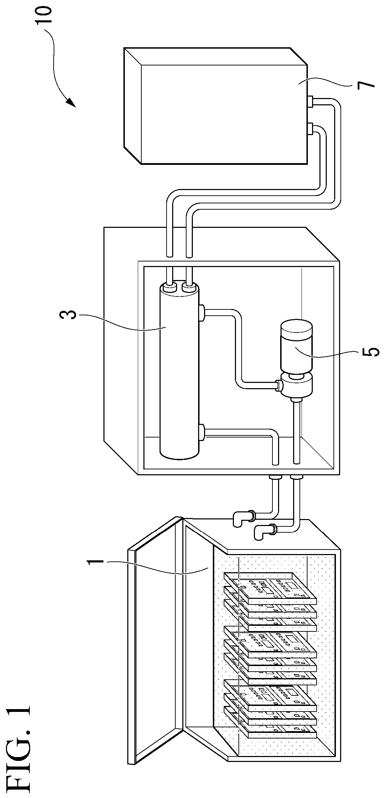

A basic configuration example of the liquid immersion cooling system is represented in FIG. 1.

A liquid immersion cooling system 10 includes a liquid immersion tank 1, a heat exchanger 3, a pump 5, and a cooling device 7. The liquid immersion tank 1 is filled with a cooling liquid for a liquid immersion cooling system.

The electronic device is cooled in the liquid immersion tank 1. The cooling liquid for a liquid immersion cooling system, which has been heated by heat dissipation of the electronic device, is pumped up by the pump 5 and is heat-exchanged with cooling water produced by the cooling device 7 in the heat exchanger 3. The cooling liquid for a liquid immersion cooling system, which has been cooled by the heat exchange, is circulated again to the liquid immersion tank 1.

By using the liquid immersion cooling system 10, it is possible to keep a safe temperature even in a case where the electronic device is continuously used in a high-load state.

Specifically, as the liquid immersion cooling system, Patent Document 1 discloses an apparatus including (a) an electronic hardware device and (b) a liquid cooling medium.

It is disclosed that the liquid cooling medium contains a mixture of (i) a synthetic ester and a saturated medium-chain triglyceride, in which the synthetic ester has a viscosity of 28 to 38 cSt at 40°C, as determined in accordance with ASTM D445, or contains (ii) a polyalkylene glycol, and in a case where the liquid cooling medium contains the polyalkylene glycol, the polyalkylene glycol constitutes at least 70% by weight of the liquid cooling medium.

### Citation List

### Patent Document

Patent Document 1: Japanese Patent No. 6282289

### Summary of Invention

### Technical Problem

The cooling liquid for a liquid immersion cooling system is also required not to affect the immersed electronic device. In order not to affect the immersed electronic device, specifically, it is required to suppress swelling of an insulating material of the electronic device or elution of a metal of the electronic device.

In the liquid cooling medium disclosed in Patent Document 1, a balance between a flash point and a viscosity is taken into consideration, but the influence on the immersed electronic device is not examined. In the ester contained in the liquid cooling medium of Patent Document 1, an acid is generated by hydrolysis, and there is a possibility that elution of a metal of the electronic device may be a problem.

In addition, from the viewpoint of maintaining high visibility in the liquid immersion cooling system, the cooling liquid for a liquid immersion cooling system is also required to have high light resistance.

The present invention has been made in view of the above circumstances, and an object thereof is to provide a cooling liquid for a liquid immersion cooling system in which light resistance is high and the influence on an electronic device to be immersed is further suppressed.

### Solution to Problem

In order to solve the above-described problem, the present invention employs the following configurations.
[1] A cooling liquid for a liquid immersion cooling system, which is contained in a liquid immersion tank of a liquid immersion cooling system as a cooling liquid, the cooling liquid containing:
   a hydrocarbon oil in an amount of 50% by mass or more with respect to a total amount of the cooling liquid for a liquid immersion cooling system,
   in which the cooling liquid for a liquid immersion cooling system contains no amine-based antioxidant, or in a case of further containing the amine-based antioxidant, the content of the amine-based antioxidant is less than 0.01% by mass with respect to the total amount of the cooling liquid for a liquid immersion cooling system,
   a 5% distillation temperature is 320°C or higher,
   a %C_{N} is 30.0 or less, and
   a kinematic viscosity at 40°C is 11.5 mm²/s or more.
[2] The cooling liquid for a liquid immersion cooling system according to [1],
   in which a 95% distillation temperature is 430°C or higher.

### Advantageous Effects of Invention

According to the present invention, it is possible to provide a cooling liquid for a liquid immersion cooling system in which light resistance is high and the influence on an electronic device to be immersed is further suppressed.

### Brief Description of Drawings

FIG. 1 is a schematic view of a liquid immersion cooling system.

### Description of Embodiments

### (Cooling liquid for liquid immersion cooling system)

The cooling liquid for a liquid immersion cooling system according to the present embodiment is a cooling liquid for a liquid immersion cooling system, which is contained in a liquid immersion tank of a liquid immersion cooling system as a cooling liquid.

The cooling liquid for a liquid immersion cooling system according to the present embodiment is used for cooling an electronic device.

As the electronic device, a computer server, a server motherboard, a microprocessor, a capacitor, and other heat-generating electronic devices are exemplary examples.

The cooling liquid for a liquid immersion cooling system according to the present embodiment contains a hydrocarbon oil in an amount of 50% by mass or more with respect to the total amount of the cooling liquid for a liquid immersion cooling system in which a 5% distillation temperature is 320°C or higher, a %C_{N} is 30.0 or less, and a kinematic viscosity at 40°C is 11.5 mm²/s or more.

In the cooling liquid for a liquid immersion cooling system according to the present embodiment, the kinematic viscosity at 40°C is 11.5 mm²/s or more, preferably 15.0 mm²/s or more, more preferably 20.0 mm²/s or more, and still more preferably 25.0 mm²/s or more.

In addition, in the cooling liquid for a liquid immersion cooling system according to the present embodiment, the kinematic viscosity at 40°C is preferably 70.0 mm²/s or less, more preferably 60.0 mm²/s or less, and still more preferably 50.0 mm²/s or less.

In the cooling liquid for a liquid immersion cooling system according to the present embodiment, since the kinematic viscosity at 40°C is 11.5 mm²/s or more, swelling of an insulating material of the electronic device can be suppressed. It is presumed that this is because a high-viscosity component (for example, a compound having a long carbon chain) is less likely to be incorporated into a resin such as the insulating material of the electronic device. In a case where the kinematic viscosity of the cooling liquid for a liquid immersion cooling system according to the present embodiment at 40°C is equal to or more than the above-described preferred lower limit value, the swelling of the insulating material of the electronic device can be further suppressed.

In a case where the kinematic viscosity of the cooling liquid for a liquid immersion cooling system according to the present embodiment at 40°C is equal to or less than the above-described preferred upper limit value, fluidity of the cooling liquid for a liquid immersion cooling system according to the present embodiment is improved, and the cooling liquid is easily circulated, so that cooling performance is improved. In addition, a load on a pump which sends out the cooling liquid in the liquid immersion cooling system can be reduced.

For example, in the cooling liquid for a liquid immersion cooling system according to the present embodiment, the kinematic viscosity at 40°C is preferably 11.5 mm²/s or more and 70.0 mm²/s or less, more preferably 15.0 mm²/s or more and 60.0 mm²/s or less, still more preferably 20.0 mm²/s or more and 60.0 mm²/s or less, and particularly preferably 25.0 mm²/s or more and 50.0 mm²/s or less.

In the cooling liquid for a liquid immersion cooling system according to the present embodiment, a kinematic viscosity at 80°C is preferably 3.5 mm²/s or more and 30.0 mm²/s or less, more preferably 4.5 mm²/s or more and 27.5 mm²/s or less, and still more preferably 5.5 mm²/s or more and 25.0 mm²/s or less.

In the cooling liquid for a liquid immersion cooling system according to the present embodiment, a kinematic viscosity at 100°C is preferably 2.5 mm²/s or more and 20.0 mm²/s or less, more preferably 3.0 mm²/s or more and 17.5 mm²/s or less, and still more preferably 3.5 mm²/s or more and 15.0 mm²/s or less.

The kinematic viscosities at 40°C, 80°C, and 100°C in the present specification mean kinematic viscosities at 40°C, 80°C, and 100°C measured in conformity with JIS K 2283:2000.

In the cooling liquid for a liquid immersion cooling system according to the present embodiment, the 5% distillation temperature is 320°C or higher, preferably 330°C or higher, more preferably 350°C or higher, and still more preferably 370°C or higher.

In addition, the 5% distillation temperature of the cooling liquid for a liquid immersion cooling system is preferably 600°C or lower, more preferably 550°C or lower, and still more preferably 520°C or lower.

By setting the 5% distillation temperature of the cooling liquid for a liquid immersion cooling system to 320°C or higher, swelling of an insulating material of the electronic device can be suppressed. It is presumed that this is because a high-boiling-point component is less likely to be incorporated into a resin such as the insulating material of the electronic device. In a case where the 5% distillation temperature of the cooling liquid for a liquid immersion cooling system is equal to or higher than the above-described preferred lower limit value, the swelling of the insulating material of the electronic device can be further suppressed.

In a case where the 5% distillation temperature of the cooling liquid for a liquid immersion cooling system is equal to or lower than the above-described preferred upper limit value, fluidity of the cooling liquid for a liquid immersion cooling system is improved, and the cooling liquid is easily circulated, so that cooling performance is improved. In addition, a load on a pump which sends out the cooling liquid in the liquid immersion cooling system can be reduced.

For example, the 5% distillation temperature of the cooling liquid for a liquid immersion cooling system according to the present embodiment is preferably 320°C or higher and 600°C or lower, more preferably 330°C or higher and 550°C or lower, still more preferably 350°C or higher and 550°C or lower, and particularly preferably 370°C or higher and 520°C or lower.

In the cooling liquid for a liquid immersion cooling system according to the present embodiment, a 95% distillation temperature is preferably 430°C or higher, more preferably 450°C or higher, and still more preferably 500°C or higher.

In addition, the 95% distillation temperature of the cooling liquid for a liquid immersion cooling system is preferably 800°C or lower, more preferably 750°C or lower, and still more preferably 700°C or lower.

In a case where the 95% distillation temperature of the cooling liquid for a liquid immersion cooling system is equal to or higher than the above-described preferred lower limit value, the swelling of the insulating material of the electronic device can be further suppressed.

In a case where the 95% distillation temperature of the cooling liquid for a liquid immersion cooling system is equal to or lower than the above-described preferred upper limit value, fluidity of the cooling liquid for a liquid immersion cooling system is improved, and the cooling liquid is easily circulated, so that cooling performance is improved. In addition, a load on a pump which sends out the cooling liquid in the liquid immersion cooling system can be reduced.

For example, the 95% distillation temperature of the cooling liquid for a liquid immersion cooling system according to the present embodiment is preferably 430°C or higher and 800°C or lower, more preferably 450°C or higher and 750°C or lower, and still more preferably 500°C or higher and 700°C or lower.

Among the above, for example, in the cooling liquid for a liquid immersion cooling system according to the present embodiment, it is preferable that the 5% distillation temperature be 320°C or higher and 600°C or lower and the 95% distillation temperature be 430°C or higher and 800°C or lower; it is more preferable that the 5% distillation temperature be 330°C or higher and 550°C or lower and the 95% distillation temperature be 450°C or higher and 750°C or lower; it is still more preferable that the 5% distillation temperature be 350°C or higher and 550°C or lower and the 95% distillation temperature be 450°C or higher and 750°C or lower; and it is particularly preferable that the 5% distillation temperature be 370°C or higher and 520°C or lower and the 95% distillation temperature be 500°C or higher and 700°C or lower.

In a case where the 5% distillation temperature and the 95% distillation temperature of the cooling liquid for a liquid immersion cooling system according to the present embodiment are within the above-described preferred ranges, cooling performance can be improved while further suppressing the swelling of the insulating material of the electronic device.

In the present specification, the 5% distillation temperature and the 95% distillation temperature mean values obtained by gas chromatography distillation measured in conformity with JIS K 2254:2018.

Measurement conditions of the gas chromatography distillation in the present specification are as follows.
(1) Case where an end point (100% distillation temperature) is 600°C or higher
   Device: GC-2030 manufactured by Shimadzu Corporation
   Column: UA-1HT (30 m × 0.5 mm I.D. × 0.10 µm)
   Carrier gas: helium 15 mL/min
   Detector: FID
   Detector temperature: 400°C
   Injection port temperature: PTV 40°C to 380°C
   Column temperature: 40°C to 380°C (6 min)
   Temperature rising rate: 10°C/min
   Injection amount: 0.5 µL (carbon disulfide solution)
(2) Case where an end point (100% distillation temperature) is lower than 600°C
   Device: GC-2010 plus manufactured by Shimadzu Corporation
   Column: UA-1HT (30 m × 0.5 mm I.D. × 0.10 µm)
   Carrier gas: helium 15 mL/min
   Detector: FID
   Detector temperature: 360°C
   Injection port temperature: PTV 40°C to 380°C
   Column temperature: 40°C to 350°C (6 min)
   Temperature rising rate: 10°C/min
   Injection amount: 0.5 µL (carbon disulfide solution)

In the cooling liquid for a liquid immersion cooling system according to the present embodiment, the %C_{N} is 30.0 or less, preferably 27.5 or less and more preferably 25.0 or less.

In addition, the %C_{N} of the cooling liquid for a liquid immersion cooling system is preferably 0.5 or more, more preferably 1.5 or more, and still more preferably 2.5 or more.

In a case where the %C_{N} of the cooling liquid for a liquid immersion cooling system is 30.0 or less, swelling of an insulating material of the electronic device can be suppressed. In a case of being equal to or less than the above-described preferred upper limit value, the swelling of the insulating material of the electronic device can be further suppressed.

In a case where the %C_{N} of the cooling liquid for a liquid immersion cooling system is equal to or more than the above-described preferred lower limit value, solubility of an additive is improved.

For example, the %C_{N} of the cooling liquid for a liquid immersion cooling system according to the present embodiment is preferably 0.5 or more and 30.0 or less, more preferably 1.5 or more and 27.5 or less, and still more preferably 2.5 or more and 25.0 or less.

A %Cₚ of the cooling liquid for a liquid immersion cooling system according to the present embodiment is preferably 99.5 or less, more preferably 98.5 or less, and still more preferably 97.5 or less.

In addition, the %Cₚ of the cooling liquid for a liquid immersion cooling system is preferably 70.0 or more, more preferably 72.5 or more, and still more preferably 75.0 or more.

In a case where the %Cₚ of the cooling liquid for a liquid immersion cooling system is equal to or less than the above-described preferred upper limit value, the solubility of the additive is further improved.

In a case where the %Cₚ of the cooling liquid for a liquid immersion cooling system is equal to or higher than the above-described preferred lower limit value, the swelling of the insulating material of the electronic device can be further suppressed.

For example, the %Cₚ of the cooling liquid for a liquid immersion cooling system according to the present embodiment is preferably 70.0 or more and 99.5 or less, more preferably 72.5 or more and 98.5 or less, and still more preferably 75.0 or more and 97.5 or less.

A %C_{A} of the cooling liquid for a liquid immersion cooling system according to the present embodiment is preferably 5.0 or less, more preferably 3.0 or less, and still more preferably 0.

In a case where the %C_{A} of the cooling liquid for a liquid immersion cooling system is equal to or less than the above-described preferred upper limit value, the cooling liquid is less likely to affect the electronic device.

In the present specification, the %C_{N}, %C_{P}, and %C_{A} are each determined by a method in conformity with ASTM D 3238-85 (n-d-M ring analysis).

The %C_{N} means a percentage (mass proportion) with respect to the total number of carbon atoms in the naphthene carbon. The %C_{P} means a percentage (mass proportion) with respect to the total number of carbon atoms in the paraffin carbon. The %C_{A} means a percentage with respect to the total number of carbon atoms in the aromatic carbon.

The above-described preferred ranges of %C_{N}, %C_{P}, and %C_{A} are based on values obtained by the above-described method, and for example, even in a mineral oil-based base oil not containing a naphthene fraction, the %C_{N} obtained by the above-described method can be a value of more than 0.

### <Hydrocarbon oil>

The cooling liquid for a liquid immersion cooling system according to the present embodiment contains a hydrocarbon oil.

As the hydrocarbon oil, aliphatic saturated hydrocarbon oil, aliphatic unsaturated hydrocarbon oil (olefin-based hydrocarbon), alicyclic hydrocarbon oil (naphthene-based hydrocarbon), and aromatic hydrocarbon oil are exemplary examples.

The aliphatic saturated hydrocarbon oil may be a linear saturated hydrocarbon oil (normal paraffin-based hydrocarbon) or a branched saturated hydrocarbon oil (isoparaffin-based hydrocarbon).

Specifically, as the hydrocarbon oil in the cooling liquid for a liquid immersion cooling system according to the present embodiment, mineral oil and synthetic oil are exemplary examples.

### <<Mineral oil>>

As the mineral oil, a distillate oil obtained by distilling a crude oil at normal pressure can be used. In addition, a lubricating oil fraction obtained by subjecting the distillate oil to further vacuum distillation and then refining by various refining processes can be used.

As the refining process, hydrogenation purification, solvent extraction, solvent dewaxing, hydrogenation dewaxing, sulfuric acid washing, clay treatment, and the like can be appropriately combined. By appropriately combining and performing these refining processes in an appropriate order, the mineral oil can be obtained.

In addition, the mineral oil also includes wax isomerized oil. The wax isomerized oil is a hydrocarbon obtained, as a lubricating oil fraction, by hydrogenating and decomposing or hydrogenating and isomerizing GTL wax or CTL wax, which is synthesized by the Fischer Tropsch method (FT method), slack wax obtained by removing a solvent, or the like. The GTL wax is synthesized by the FT method using natural gas as a raw material, and the CTL wax is synthesized by the FT method using coal as a raw material. The hydrocarbon obtained, as a lubricating oil fraction, by hydrogenating and decomposing or hydrogenating and isomerizing these waxes is generally referred to as GTL or CTL.

As the mineral oil, a mixture of a plurality of refined oils having different properties, which are obtained by supplying different crude oils or distillate oils to a combination of different refining processes, or a mixture with GTL or the like may be used.

As the mineral oil, a group I base oil according to API base oil classification (hereinafter, referred to as "API group I base oil"), a group II base oil according to API base oil classification (hereinafter, referred to as "API group 11 base oil"), a group III base oil according to API base oil classification (hereinafter, referred to as "API group III base oil"), or a mixed base oil thereof can be used.

The API group I base oil is a mineral oil-based base oil having a sulfur content of more than 0.03% by mass and/or a saturation of less than 90% by mass, and a viscosity index of 80 or more and less than 120.

The API group II base oil is a mineral oil-based base oil having a sulfur content of 0.03% by mass or more, a saturation of 90% by mass or more, and a viscosity index of 80 or more and less than 120.

The API group III base oil is a mineral oil-based base oil having a sulfur content of 0.03% by mass or less, a saturation of 90% by mass or more, and a viscosity index of 120 or more.

The hydrocarbon oil may be one kind of mineral oil or a mixed base oil including two or more kinds of mineral oils. In the mixed base oil including two or more mineral oils, the API classification of the mineral oils may be the same or different from each other.

From the viewpoint of further suppressing the influence on the electronic device, the mineral oil in the cooling liquid for a liquid immersion cooling system according to the present embodiment preferably contains the API group III base oil.

### <<Synthetic oil>>

As the synthetic oil, polyolefin, alkylbenzene, and the like are exemplary examples.

### · Polyolefin

As the polyolefin, compounds obtained by homopolymerizing or copolymerizing olefin monomers having 2 to 16 carbon atoms, preferably 2 to 12 carbon atoms, and hydrides of these polymers are exemplary examples. The above-described olefin monomer may be any of an α-olefin, an internal olefin, a linear olefin, and a branched olefin. As such an olefin monomer, specifically, ethylene, propylene, 1-butene, 2-butene, isobutene, pentene, hexene, heptene, octene, nonene, decene, undecene, dodecene, tridecene, tetradecene, pentadecene, hexadecene, and a mixture thereof are exemplary examples.

Among the above, from the viewpoint of viscosity characteristics and oxidation stability, poly-α-olefin (PAO) is preferable as the polyolefin.

The above-described polyolefin can be manufactured by a known method. For example, a desired polyolefin can be manufactured by performing a thermal reaction without a catalyst, or by homopolymerizing or copolymerizing the olefins using known catalysts such as an organic peroxide catalyst such as benzoyl peroxide; a Friedel-Craft type catalyst such as aluminum chloride, an aluminum chloride-polyhydric alcohol-based catalyst, an aluminum chloride-titanium tetrachloride-based catalyst, an aluminum chloride-alkyl tin halide-based catalyst, and boron fluoride; a Ziegler type catalyst such as an organic aluminum chloride-titanium tetrachloride-based catalyst and an organic aluminum-titanium tetrachloride-based catalyst; a metallocene type catalyst such as an aluminoxane-zirconocene-based metallocene type catalyst and an ionic compound-zirconocene-based metallocene type catalyst; and a Lewis acid complex type catalyst such as an aluminum chloride-base-based Lewis acid complex type catalyst and a boron fluoride-base-based Lewis acid complex type catalyst.

### · Alkylbenzene

As the alkylbenzene, alkylbenzene having 1 to 4 alkyl groups having 1 to 40 carbon atoms in the molecule is preferable. In addition, the alkyl group of the alkylbenzene may be linear or branched. From the viewpoint of stability, viscosity characteristics, and the like, a branched alkyl group is preferable, and from the viewpoint of easy availability, a branched alkyl group derived from an oligomer of an olefin such as propylene, butene, and isobutylene is more preferable.

Among the above, as the alkylbenzene in the present embodiment, from the viewpoint of stability and availability, alkylbenzene having 1 or 2 alkyl groups, that is, monoalkylbenzene, dialkylbenzene, or a mixture thereof is most preferable. In addition, the alkylbenzene may be not only a single-structured alkylbenzene but also a mixture of alkylbenzenes having different structures.

The above-described alkylbenzene can be manufactured by a known method. For example, the alkylbenzene can be manufactured by using an aromatic compound as a raw material, and using an alkylating agent and an alkylation catalyst.

As the aromatic compound used as a raw material, specifically, benzene, toluene, xylene, ethylbenzene, methylethylbenzene, diethylbenzene, and a mixture thereof are exemplary examples.

As the alkylating agent, specifically, lower monoolefins such as ethylene, propylene, butene, and isobutylene, preferably a linear or branched olefin having 6 to 40 carbon atoms obtained by polymerization of propylene; a linear or branched olefin having 6 to 40 carbon atoms obtained by thermal decomposition of a wax, a heavy oil, a petroleum distillate, polyethylene, and polypropylene; a linear olefin having 9 to 40 carbon atoms obtained by separating n-paraffins from petroleum distillates such as kerosene and a light oil, and olefinizing these with a catalyst; and a mixture thereof are exemplary examples.

As the alkylation catalyst, known catalysts such as a Friedel-Craft type catalyst such as aluminum chloride and zinc chloride; and an acidic catalyst such as sulfuric acid, phosphoric acid, silicotungstic acid, hydrofluoric acid, and active white clay are exemplary examples.

The hydrocarbon oil in the cooling liquid for a liquid immersion cooling system according to the present embodiment may include a hydrocarbon oil having biomass-derived carbon.

As the hydrocarbon oil having biomass-derived carbon, specifically, base oils synthesized from plant oils such as palm oil, coconut oil, soybean oil, rapeseed oil, and a mixture thereof are exemplary examples.

As a commercially available product of the hydrocarbon oil having biomass-derived carbon, SynNova^{™} 4 Base Oil (manufactured by Novvi, LLC), SynNova^{™} 9 Base Oil (manufactured by Novvi, LLC), and the like are exemplary examples.

As the hydrocarbon oil in the cooling liquid for a liquid immersion cooling system according to the present embodiment, only the mineral oil may be used, only the synthetic oil may be used, or a mixture of the mineral oil and the synthetic oil may be used. Among these, the API group III base oil or the poly-α-olefin is preferable.

A 5% distillation temperature of the hydrocarbon oil in the cooling liquid for a liquid immersion cooling system according to the present embodiment is preferably 320°C or higher, more preferably 330°C or higher, and still more preferably 350°C or higher.

In addition, the 5% distillation temperature of the hydrocarbon oil is preferably 600°C or lower, more preferably 550°C or lower, and still more preferably 520°C or lower.

In a case where the 5% distillation temperature of the hydrocarbon oil is equal to or more than the above-described preferred lower limit value, the swelling of the insulating material of the electronic device can be further suppressed.

In a case where the 5% distillation temperature of the hydrocarbon oil is equal to or lower than the above-described preferred upper limit value, fluidity of the cooling liquid for a liquid immersion cooling system according to the present embodiment is improved, and the cooling liquid is easily circulated, so that cooling performance is improved. In addition, a load on a pump which sends out the cooling liquid in the liquid immersion cooling system can be reduced.

For example, the 5% distillation temperature of the hydrocarbon oil in the cooling liquid for a liquid immersion cooling system according to the present embodiment is preferably 320°C or higher and 600°C or lower, more preferably 330°C or higher and 550°C or lower, and still more preferably 350°C or higher and 520°C or lower.

A 95% distillation temperature of the hydrocarbon oil in the cooling liquid for a liquid immersion cooling system according to the present embodiment is preferably 430°C or higher, more preferably 450°C or higher, and still more preferably 500°C or higher.

In addition, the 95% distillation temperature of the hydrocarbon oil is preferably 800°C or lower, more preferably 750°C or lower, and still more preferably 700°C or lower.

In a case where the 95% distillation temperature of the hydrocarbon oil is equal to or more than the above-described preferred lower limit value, the swelling of the insulating material of the electronic device can be further suppressed.

In a case where the 95% distillation temperature of the hydrocarbon oil is equal to or lower than the above-described preferred upper limit value, fluidity of the cooling liquid for a liquid immersion cooling system according to the present embodiment is improved, and the cooling liquid is easily circulated, so that cooling performance is improved. In addition, a load on a pump which sends out the cooling liquid in the liquid immersion cooling system can be reduced.

For example, the 95% distillation temperature of the hydrocarbon oil in the cooling liquid for a liquid immersion cooling system according to the present embodiment is preferably 430°C or higher and 800°C or lower, more preferably 450°C or higher and 750°C or lower, and still more preferably 500°C or higher and 700°C or lower.

Among the above, for example, in hydrocarbon oil in the cooling liquid for a liquid immersion cooling system according to the present embodiment, it is preferable that the 5% distillation temperature be 320°C or higher and 600°C or lower and the 95% distillation temperature be 430°C or higher and 800°C or lower; it is more preferable that the 5% distillation temperature be 330°C or higher and 550°C or lower and the 95% distillation temperature be 450°C or higher and 750°C or lower; and it is still more preferable that the 5% distillation temperature be 350°C or higher and 550°C or lower and the 95% distillation temperature be 500°C or higher and 700°C or lower.

In a case where the 5% distillation temperature and the 95% distillation temperature of the hydrocarbon oil in the cooling liquid for a liquid immersion cooling system according to the present embodiment are within the above-described preferred ranges, cooling performance can be improved while further suppressing the swelling of the insulating material of the electronic device.

The hydrocarbon oil in the cooling liquid for a liquid immersion cooling system according to the present embodiment may be used alone or in combination of two or more kinds thereof.

In a case where the cooling liquid for a liquid immersion cooling system according to the present embodiment contains two or more kinds of hydrocarbon oils, the "5% distillation temperature" and "95% distillation temperature" described above mean values obtained by gas chromatography distillation of a mixture of the two or more kinds of hydrocarbon oils.

The content of the hydrocarbon oil in the cooling liquid for a liquid immersion cooling system according to the present embodiment is 50% by mass or more with respect to the total amount of the cooling liquid for a liquid immersion cooling system, preferably 80% by mass or more, more preferably 90% by mass or more, still more preferably 95% by mass or more, and may be 100% by mass.

In a case where the content of the hydrocarbon oil in the cooling liquid for a liquid immersion cooling system according to the present embodiment is equal to or more than the above-described preferred lower limit value, the influence on the electronic device can be further suppressed.

The cooling liquid for a liquid immersion cooling system according to the present embodiment contains the above-described hydrocarbon oil, and does not substantially contain an amine-based antioxidant.

Here, "does not substantially contain an amine-based antioxidant" has the following two meanings.
(i) an amine-based antioxidant is not contained.
(ii) in a case of containing an amine-based antioxidant, the total content of the amine-based antioxidant is less than 0.01% by mass with respect to the total amount of the cooling liquid for a liquid immersion cooling system.

Since the cooling liquid for a liquid immersion cooling system does not substantially contain an amine-based antioxidant, light resistance is favorable. The light resistance of the cooling liquid is not particularly a problem in other applications. Meanwhile, in a case of being used in a liquid immersion cooling system, the electronic device needs to be immersed in the cooling liquid for a liquid immersion cooling system, and it is required to be observed in a state of being immersed in the cooling liquid for a liquid immersion cooling system during maintenance. Therefore, it is important to maintain transparency of the cooling liquid for a liquid immersion cooling system.

The cooling liquid for a liquid immersion cooling system does not substantially contain an amine-based antioxidant. Therefore, the light resistance is favorable, the transparency is easily maintained, and the maintainability of the electronic device immersed in the cooling liquid for a liquid immersion cooling system is improved.

### · Amine-based antioxidant

As the amine-based antioxidant, an aromatic amine-based antioxidant, a hindered amine-based antioxidant, and the like are exemplary examples.

As the aromatic amine-based antioxidant, a primary aromatic amine compound such as alkylated α-naphthylamine; and a secondary aromatic amine compound such as alkylated diphenylamine, phenyl-α-naphthylamine, alkylated phenyl-α-naphthylamine, and phenyl-β-naphthylanune are exemplary examples.

As the hindered amine-based antioxidant, compounds having a 2,2,6,6-tetraalkylpiperidine skeleton (2,2,6,6-tetraalkylpiperidine derivatives) are exemplary examples.

As the 2,2,6,6-tetraalkylpiperidine derivative, a 2,2,6,6-tetraalkylpiperidine derivative having a substituent at a 4-position is an exemplary example. In addition, two 2,2,6,6-tetraalkylpiperidine skeletons may be bonded through substituents at the 4-positions thereof. In addition, an N-position of the 2,2,6,6-tetraalkylpiperidine skeleton may be unsubstituted, or an alkyl group having 1 to 4 carbon atoms may be substituted on the N-position.

The 2,2,6,6-tetraalkylpiperidine skeleton is, for example, a 2,2,6,6-tetramethylpiperidine skeleton.

As the substituent of the 2,2,6,6-tetraalkylpiperidine skeleton at the 4-position, an acyloxy group (R¹COO-), an alkoxy group (R¹O-), an alkylamino group (R¹NH-), and an acylamino group (R¹CONH-) are exemplary examples.

R¹ is, for example, a hydrocarbon group having 1 to 30 carbon atoms.

As the hydrocarbon group, an alkyl group, an alkenyl group, a cycloalkyl group, an alkylcycloalkyl group, an aryl group, an alkylaryl group, and an arylalkyl group are exemplary examples.

As the substituent in a case where two 2,2,6,6-tetraalkylpiperidine skeletons may be bonded through substituents at the 4-positions thereof, a hydrocarbylenebis(carbonyloxy) group (-OOC-R²-COO-), a hydrocarbylene diamino group (-HN-R²-NH-), and a hydrocarbylenebis(carbonylamino) group (-HNCO-R²-CONH-) are exemplary examples. R² is, for example, a hydrocarbylene group having 1 to 30 carbon atoms.

As the substituent of the 2,2,6,6-tetraalkylpiperidine skeleton at the 4-position, an acyloxy group is an exemplary example. As the compound having an acyloxy group at the 4-position of the 2,2,6,6-tetraalkylpiperidine skeleton, an ester of 2,2,6,6-tetramethyl-4-piperidinol and a carboxylic acid is an exemplary example.

As the carboxylic acid, a linear or branched aliphatic carboxylic acid having 8 to 20 carbon atoms is an exemplary example.

The content of the hydrocarbon oil in the cooling liquid for a liquid immersion cooling system is preferably 99.9% by mass or more, and may be 100% by mass with respect to the total amount of the cooling liquid for a liquid immersion cooling system.

The cooling liquid for a liquid immersion cooling system according to the embodiment is a cooling liquid for a liquid immersion cooling system consisting of only the above-described hydrocarbon oil.

The content of the amine-based antioxidant in the cooling liquid for a liquid immersion cooling system is less than 0.01% by mass, preferably less than 0.001% by mass with respect to the total amount of the cooling liquid for a liquid immersion cooling system, and it is more preferable that the cooling liquid for a liquid immersion cooling system not contain the amine-based antioxidant.

The cooling liquid for a liquid immersion cooling system may contain an optional component.

In a case where the cooling liquid for a liquid immersion cooling system contains an optional component, the content of the optional component is preferably 0.1% by mass or less with respect to the total amount of the cooling liquid for a liquid immersion cooling system.

### <Optional component>

The cooling liquid for a liquid immersion cooling system according to the present embodiment may contain an optional component other than the above-described hydrocarbon oil. As the optional component, an antioxidant other than the amine-based antioxidant, a metal deactivator, a rust preventive, an antifoaming agent, a metal cleaner, an abrasion inhibitor, a viscosity index improver, a pour point depressant, a mist inhibitor, and a demulsifier are exemplary examples.

### <<Other antioxidants>>

As other antioxidants, specifically, peroxide decomposers such as a phenol-based antioxidant, a sulfur-based antioxidant, and a sulfur/phosphorus-based antioxidant are exemplary examples.

### <<Metal deactivator>>

As the metal deactivator, for example, a benzotriazole-based compound, a tolyltriazole-based compound, a thiazole-based compound, and an imidazole-based compound are exemplary examples.

### <<Antifoaming agent>>

As the antifoaming agent, silicone-based antifoaming agents are exemplary examples.

### <<Viscosity index improver>>

As the viscosity index improver, for example, a non-dispersed or dispersed poly(meth)acrylate-based viscosity index improver, a non-dispersed or dispersed olefin-(meth)acrylate copolymer-based viscosity index improver, a styrene-maleic acid ester copolymer-based viscosity index improver, and a mixture thereof are exemplary examples.

### <<Pour point depressant>>

As the pour point depressant, for example, a polymethacrylate-based polymer compatible with the above-described hydrocarbon oil is an exemplary example.

### <<Mist inhibitor>>

As the mist inhibitor, for example, an ethylene-propylene copolymer, polymethacrylate, polyisobutylene, and polybutene are exemplary examples. An average molecular weight of these compounds as the mist inhibitor is usually 10,000 to 8,000,000.

An acid value of the cooling liquid for a liquid immersion cooling system according to the present embodiment is preferably 0.1 mg KOH/g or less, and more preferably 0.05 mg KOH/g or less.

In a case where the acid value of the cooling liquid for a liquid immersion cooling system according to the present embodiment is equal to or less than the above-described preferred upper limit value, corrosion resistance to a metal used in the electronic device to be immersed is further improved.

The acid value represents a value of the total acid value measured in conformity with JIS K 2501 "Petroleum products and lubricants-Determination of neutralization number".

### [Examples]

Hereinafter, the effects of the present invention will be described in detail with reference to Examples and Comparative Examples, but the present invention is not limited to the following Examples.

### <Formulation of cooling liquid for liquid immersion cooling system>

Cooling liquids for a liquid immersion cooling system of Examples 1 to 13 and Comparative Examples 1 and 2, which were formulated with proportions shown in Tables 1 to 6, were produced. Numerical values in Tables 1 to 6 indicate % by mass with respect to the total amount of the cooling liquid for a liquid immersion cooling system.

Details of each component contained in the cooling liquid for a liquid immersion cooling system are as follows.

### <Hydrocarbon oil>

(A-1): mineral oil (kinematic viscosity at 40°C: 44.9 mm²/s, 5% distillation temperature: 412°C, 95% distillation temperature: 554°C, %C_{P}: 80.4, %C_{N}: 19.6, %C_{A}: 0)
(A-2): poly-α-olefin (kinematic viscosity at 40°C: 45.8 mm²/s, 5% distillation temperature: 463°C, 95% distillation temperature: 581°C, %C_{P}: 91.6, %C_{N}: 8.4, %C_{A}: 0)
(A-3): poly-α-olefin (kinematic viscosity at 40°C: 48.0 mm²/s, 5% distillation temperature: 426°C, 95% distillation temperature: 593°C, %C_{P}: 90.9, %C_{N}: 9.1, %C_{A}: 0)
(A-4): poly-α-olefin (kinematic viscosity at 40°C: 17.4 mm²/s, 5% distillation temperature: 412°C, 95% distillation temperature: 487°C, %C_{P}: 91.4, %C_{N}: 8.6, %C_{A}: 0)
(A-5): mineral oil (kinematic viscosity at 40°C: 8.7 mm²/s, 5% distillation temperature: 271°C, 95% distillation temperature: 418°C, %C_{P}: 65.3, %C_{N}: 34.7, %C_{A}: 0)
(A-6): mineral oil (kinematic viscosity at 40°C: 37.8 mm²/s, 5% distillation temperature: 377°C, 95% distillation temperature: 520°C, %C_{P}: 71.0, %C_{N}: 29.0, %C_{A}: 0)
(A-7): 100% plant-derived hydrocarbon oil (product name "SynNova 4^{™} Base Oil", manufactured by Novvi, LLC, kinematic viscosity at 40°C: 19.7 mm²/s, 5% distillation temperature: 425°C, 95% distillation temperature: 461°C, %C_{P}: 93.1, %C_{N}: 6.9, %C_{A}: 0)
(A-8): mineral oil (kinematic viscosity at 40°C: 34.8 mm²/s, 5% distillation temperature: 413°C, 95% distillation temperature: 528°C, %C_{P}: 84.3, %C_{N}: 15.7, %C_{A}: 0)
(a-1): mineral oil (kinematic viscosity at 40°C: 54.8 mm²/s, 5% distillation temperature: 319°C, 95% distillation temperature: 438°C, %C_{P}: 38.3, %C_{N}: 49.6, %C_{A}: 12.2)
(a-2): poly-α-olefin (kinematic viscosity at 40°C: 5.0 mm²/s, 5% distillation temperature: 308°C, 95% distillation temperature: 332°C, %C_{P}: 85.5, %C_{N}: 12.5, %C_{A}: 2)
(a-3): ester oil (78:22 mixed oil of product name "UNISTER (registered trademark) H-281R" and product name "UNISTER (registered trademark) H-381R", both manufactured by NOF CORPORATION) (kinematic viscosity at 40°C: 28.6 mm²/s, 5% distillation temperature: 408°C, 95% distillation temperature: 615°C, %C_{P}: 31.6, %C_{N}: 68.4, %C_{A}: 0)

### <Antioxidant>

(B-1): phenol-based antioxidant (compound name "octyl-3-(3,5-di-tert-butyl-4-hydroxyphenyl)propionate")
(b-1): amine-based antioxidant (compound name "monobutylphenyl monooctylphenylamine")
(b-2): amine-based antioxidant (compound name "N-dodecylphenyl-1-naphthylamine")

### [Evaluation of influence on electronic device]

50 mL of the cooling liquid for a liquid immersion cooling system of each of Examples was added to a 100 mL beaker, and two capacitors (manufactured by AVX Components Corporation, SCCR20B335PRBLE) having the coating peeled off and the terminal cut off were immersed in the cooling liquid. The length (mm) of the insulating material of the capacitor immersed at 80°C for one week and swollen was measured, and the influence (swelling property) on the electronic device was evaluated. Tables 1 to 6 show the average value of the measured lengths and the results evaluated by the following determination standard.

### <<Determination standard for immersing test>>

A: length of the insulating material of the capacitor swelled and stretched was less than 0.29 mm.
B: length of the insulating material of the capacitor swelled and stretched was 0.29 mm or more and less than 0.39 mm.
C: length of the insulating material of the capacitor swelled and stretched was 0.39 mm or more.

### [Evaluation of kinematic viscosity]

Tables 1 to 6 show kinematic viscosities of the cooling liquid for a liquid immersion cooling system of each of Examples at 40°C, 80°C, and 100°C, which were measured in conformity with JIS K 2283:2000.

### [Evaluation of distillation properties]

Tables 1 to 6 show the 5% distillation temperature and the 95% distillation temperature of the cooling liquid for a liquid immersion cooling system of each of Examples, which were measured under the following conditions in conformity with JIS K 2254: 2018.

### <<Measurement conditions>>

(1) Case where an end point (100% distillation temperature) was 600°C or higher
   Device: GC-2030 manufactured by Shimadzu Corporation
   Column: UA-1HT (30 m × 0.5 mm I.D. × 0.10 µm)
   Carrier gas: helium 15 mL/min
   Detector: FID
   Detector temperature: 400°C
   Injection port temperature: PTV 40°C to 380°C
   Column temperature: 40°C to 380°C (6 min)
   Temperature rising rate: 10°C/min
   Injection amount: 0.5 µL (carbon disulfide solution)
(2) Case where an end point (100% distillation temperature) was lower than 600°C
   Device: GC-2010 plus manufactured by Shimadzu Corporation
   Column: UA-1HT (30 m × 0.5 mm I.D. × 0.10 µm)
   Carrier gas: helium 15 mL/min
   Detector: FID
   Detector temperature: 360°C
   Injection port temperature: PTV 40°C to 380°C
   Column temperature: 40°C to 350°C (6 min)
   Temperature rising rate: 10°C/min
   Injection amount: 0.5 µL (carbon disulfide solution)

### [Evaluation of acid value]

Tables 1 to 6 show the acid value of the cooling liquid for a liquid immersion cooling system of each of Examples, which was measured in conformity with JIS K 2501:2003.

From the viewpoint of further suppressing elution of the metal, a value of 0.1 or less was determined to be acceptable.

### [Evaluation of light resistance]

80 mL of the cooling liquid for a liquid immersion cooling system of each of Examples was charged into a 100 mL screw bottle, the screw bottle was left standing at a window for 4 days, and the hue was observed in conformity with JIS K 2580.

**[Table 1]**

| | | | Example 1 |
|---|---|---|---|
| A-1 | | mass% | 100 |
| Properties of cooling liquid | Kinematic viscosity (25°C) | mm²/s | 90.1 |
| | Kinematic viscosity (40°C) | | 44.9 |
| | Kinematic viscosity (80°C) | | 12.0 |
| | Kinematic viscosity (100°C) | | 7.5 |
| | n-d-M analysis (20°C) | % C_{P} | 80.4 |
| | | %C_{N} | 19.6 |
| | | %C_{A} | 0.0 |
| | 5% Distillation temperature | °C | 412 |
| | 95% Distillation temperature | °C | 554 |
| Evaluation of cooling liquid | Capacitor immersion test | mm | 0.19 |
| | 80°C, 1 week | | |
| | Immersion test determination | | A |
| | Acid value | mg KOH/g | 0.01 |
| | Light resistance | Color (ASTM) | 0.0 |

**[Table 2]**

| | | | Example 2 | Example 3 | Example 4 |
|---|---|---|---|---|---|
| A-2 | | mass% | 100 | - | - |
| A-3 | | mass% | - | 100 | - |
| A-4 | | mass% | - | - | 100 |
| Properties of cooling liquid | Kinematic viscosity (25°C) | mm²/s | 90.3 | 96.6 | 31.2 |
| | Kinematic viscosity (40°C) | | 45.8 | 48.0 | 17.4 |
| | Kinematic viscosity (80°C) | | 12.6 | 12.7 | 5.8 |
| | Kinematic viscosity (100°C) | | 7.9 | 8.0 | 3.9 |
| | n-d-M analysis (20°C) | %C_{P} | 91.6 | 90.9 | 91.4 |
| | | %C_{N} | 8.4 | 9.1 | 8.6 |
| | | %C_{A} | 0.0 | 0.0 | 0.0 |
| | 5% Distillation temperature | °C | 463 | 426 | 412 |
| | 95% Distillation temperature | °C | 581 | 593 | 487 |
| Evaluation of cooling liquid | Capacitor immersion test | mm | 0.10 | 0.09 | 0.24 |
| | 80°C, 1 week | | | | |
| | Immersion test determination | | A | A | A |
| | Acid value | mg KOH/g | 0.01 | 0.01 | 0.01 |
| | Light resistance | Color (ASTM) | 0.0 | 0.0 | 0.0 |

**[Table 3]**

| | | | Example 5 | Example 6 | Comparative Example 1 |
|---|---|---|---|---|---|
| A-5 | | mass% | - | 15 | - |
| A-1 | | mass% | - | 85 | - |
| A-6 | | mass% | 100 | - | - |
| A-1 | | mass% | - | - | 100 |
| Properties of cooling liquid | Kinematic viscosity (25°C) | mm²/s | 77.8 37.8 | 66.8 34.4 | 143 54.8 |
| | Kinematic viscosity (40°C) | | | | |
| | Kinematic viscosity (80°C) | | 9.9 | 9.8 | 10.1 |
| | Kinematic viscosity (100°C) | | 6.2 | 6.3 | 5.8 |
| | n-d-M analysis (20°C) | %C_{P} | 71.0 | 78.2 | 38.3 |
| | | %C_{N} | 29.0 | 21.8 | 49.6 |
| | | %C_{A} | 0.0 | 0.0 | 12.2 |
| | 5% Distillation temperature | °C | 377 | 338 | 319 |
| | 95% Distillation temperature | °C | 520 | 552 | 438 |
| Evaluation of cooling liquid | Capacitor immersion test | mm | 0.29 | 0.25 | 0.39 |
| | 80°C, 1 week | | | | |
| | Immersion test determination | | B | A | C |
| | Acid value | mg KOH/g | 0.01 | 0.01 | 0.01 |
| | Light resistance | Color (ASTM) | 0.0 | 0.0 | 1.4 |

**[Table 4]**

| | | | Example 7 |
|---|---|---|---|
| A-7 | | mass% | 100 |
| Properties of cooling liquid | Kinematic viscosity (25°C) | mm²/s | 35.6 |
| | Kinematic viscosity (40°C) | | 19.8 |
| | Kinematic viscosity (80°C) | | 6.5 |
| | Kinematic viscosity (100°C) | | 4.4 |
| | n-d-M analysis (20°C) | %C_{P} | 92.9 |
| | | %C_{N} | 7.1 |
| | | %C_{A} | 0.0 |
| | 5% Distillation temperature | °C | 429 |
| | 95% Distillation temperature | °C | 458 |
| Evaluation of cooling liquid | Capacitor immersion test | mm | 0.25 |
| | 80°C, 1 week | | |
| | Immersion test determination | | A |
| | Acid value | mg KOH/g | 0.01 |
| | Light resistance | Color (ASTM) | 0.0 |

**[Table 5]**

| | | | Comparative Example 2 | Comparative Example 3 | Comparative Example 4 | Example 8 | Comparative Example 5 |
|---|---|---|---|---|---|---|---|
| A-8 | | mass% | 99.5 | 99.8 | - | 100 | - |
| a-2 | | mass% | - | - | 100 | - | - |
| a-3 | | mass% | - | - | - | - | 100 |
| b-1 | | mass% | 0.5 | - | - | - | - |
| B-2 | | mass% | - | 0.2 | - | - | - |
| Properties of cooling liquid | Kinematic viscosity (25°C) | mm²/s | 66.8 | 66.8 | 7.7 | 66.8 | 49.0 |
| | Kinematic viscosity (40°C) | | 34.8 | 34.8 | 5.0 | 34.8 | 28.6 |
| | Kinematic viscosity (80°C) | | 10.1 | 10.1 | 2.2 | 10.1 | 9.8 |
| | Kinematic viscosity (100°C) | | 6.5 | 6.5 | 1.7 | 6.5 | 6.6 |
| | n-d-M analysis (20°C) | %C_{P} | 84.2 | 84.2 | 85.5 | 84.3 | 31.6 |
| | | %C_{N} | 15.8 | 15.8 | 12.5 | 15.7 | 68.4 |
| | | %C_{A} | 0.0 | 0.0 | 2.0 | 0.0 | 0.0 |
| | 5% Distillation temperature | °C | 413 | 413 | 308 | 413 | 408 |
| | 95% Distillation temperature | °C | 528 | 528 | 332 | 528 | 615 |
| Evaluation of cooling liquid | Capacitor immersion test | mm | 0.23 | 0.22 | 0.40 | 0.23 | 0.08 |
| | 80°C, 1 week | | | | | | |
| | Immersion test determination | | A | A | C | A | A |
| | Acid value | mg KOH/g | 0.01 | 0.01 | 0.01 | 0.01 | 0.33 |
| | Light resistance | Color (ASTM) | 0.6 | 2.3 | 0.0 | 0.3 | 0.2 |

**[Table 6]**

| | | | Example 9 |
|---|---|---|---|
| A-2 | | mass% | - |
| A-3 | | mass% | 99.9 |
| A-1 | | mass% | - |
| B-1 | | mass% | 0.1 |
| Properties of cooling liquid | Kinematic viscosity (25°C) | mm²/s | 66.8 |
| | Kinematic viscosity (40°C) | | 34.8 |
| | Kinematic viscosity (80°C) | | 10.1 |
| | Kinematic viscosity (100°C) | | 6.5 |
| | n-d-M analysis (20°C) | %C_{P} | 84.2 |
| | | %C_{N} | 15.8 |
| | | %C_{A} | 0.0 |
| | 5% Distillation temperature | °C | 413 |
| | 95% Distillation temperature | °C | 528 |
| Evaluation of cooling liquid | Capacitor immersion test | mm | 0.22 |
| | 80°C, 1 week | | |
| | Immersion test determination | | A |
| | Acid value | mg KOH/g | 0.01 |
| | Light resistance | Color (ASTM) | 0.4 |

As shown in Tables 1 to 6, it was found that the cooling liquids for a liquid immersion cooling system of Examples could achieve both light resistance and a suppression effect of the influence on the electronic device to be immersed, compared with the cooling liquids for a liquid immersion cooling system of Comparative Examples.

In the cooling liquids for a liquid immersion cooling system of Examples, in which the 5% distillation temperature was 320°C or higher, the %C_{N} was 30.0 or less, and the kinematic viscosity at 40°C was 11.5 mm²/s or more, the swelling of the insulating material of the capacitor was suppressed, compared with the cooling liquid for a liquid immersion cooling system of Comparative Example 1, in which the 5% distillation temperature was lower than 320°C and the %C_{N} was more than 30.0, and the cooling liquid for a liquid immersion cooling system of Comparative Example 4, in which the 5% distillation temperature was lower than 320°C and the kinematic viscosity at 40°C was less than 11.5 mm²/s.

Therefore, it was found that the cooling liquids for a liquid immersion cooling system of Examples suppressed the influence on the electronic device to be immersed.

In the cooling liquid for a liquid immersion cooling system of Comparative Example 5, since the ester oil was used instead of the hydrocarbon oil, the acid value was high.

Therefore, it was presumed that the cooling liquid for a liquid immersion cooling system of Comparative Example 5 was more likely to elute the metal of the electronic device than the cooling liquids for a liquid immersion cooling system of Examples.

Although preferred examples of the present invention are described above, the present invention is not limited to these examples. It is possible to add other configurations or to omit, replace, or modify the configurations described herein without departing from the spirit of the present invention. The present invention is not limited by the above description, but only by the scope of the appended claims.

### Reference Signs List

10: Liquid immersion cooling system
1: Liquid immersion tank
3: Heat exchanger
5: Pump
7: Cooling device

## Claims

1. A cooling liquid for a liquid immersion cooling system, which is contained in a liquid immersion tank of a liquid immersion cooling system as a cooling liquid, the cooling liquid comprising:
a hydrocarbon oil in an amount of 50% by mass or more with respect to a total amount of the cooling liquid for a liquid immersion cooling system,
wherein the cooling liquid for a liquid immersion cooling system contains no amine-based antioxidant, or in a case of further containing the amine-based antioxidant, the content of the amine-based antioxidant is less than 0.01% by mass with respect to the total amount of the cooling liquid for a liquid immersion cooling system,
a 5% distillation temperature is 320°C or higher,
a %C_{N} is 30.0 or less, and
a kinematic viscosity at 40°C is 11.5 mm²/s or more.

2. The cooling liquid for a liquid immersion cooling system according to Claim 1,
wherein a 95% distillation temperature is 430°C or higher.
